# EUROPÄISCHE PATENTANMELDUNG

(11) **EP 3 809 511 A1**
(43) Veröffentlichungstag der Anmeldung: **21.04.2021**
(21) Anmeldenummer: 19203637.4
(22) Anmeldetag: 16.10.2019
(51) Int. Cl.: H01M 10/42, H01M 10/44, H01M 10/48, H02J 7/00

(54) **VERFAHREN ZUM STEUERN UND REGELN EINES AKKUMULATORS**

(71) Anmelder: Hilti Aktiengesellschaft, 9494 Schaan (LI)
(72) Erfinder: Goyal, Varnim, 86916 Kaufering (DE); Ziegler, Bernd, 86830 Schabmünchen (DE)
(74) Vertreter: Hilti Aktiengesellschaft Corporate Intellectual Property

(57) **Zusammenfassung**

Verfahren zum Steuern und Regeln eines Akkumulators mit wenigstens einer ersten und zweiten Energiespeicherzelle, einer Steuerungselektronik, einer Spannungsmesseinrichtung sowie wenigstens einer Sensoreinrichtung, wobei die Sensoreinrichtung und die Energiespeicherzellen jeweils über wenigstens ein ansteuerbares Schaltelement so miteinander verbunden sind, dass elektrische Energie von den Energiespeicherzellen an die Sensoreinrichtung geleitete werden kann.

Das Verfahren enthält die Verfahrensschritte: Erfassen eines ersten Spannungswertes der ersten und zweiten Energiespeicherzelle durch die Spannungsmesseinrichtung und Einstellen des wenigstens einen Schaltelements von einem Deaktivierungsmodus in einen Aktivierungsmodus, wenn die Differenz zwischen dem Spannungswert der ersten Energiespeicherzelle und dem Spannungswert der zweiten Energiespeicherzelle einen vorbestimmten Schwellwert erreicht, um elektrische Spannung von der Energiespeicherzelle mit dem höheren Spannungswert an die Sensoreinrichtung zu leiten.

## Beschreibung

Die vorliegende Erfindung betrifft ein Verfahren zum Steuern und Regeln eines Akkumulators mit wenigstens einer ersten und zweiten Energiespeicherzelle, einer Steuerungselektronik, einer Spannungsmesseinrichtung sowie wenigstens einer Sensoreinrichtung, wobei die Sensoreinrichtung und die Energiespeicherzellen jeweils über wenigstens ein ansteuerbares Schaltelement so miteinander verbunden sind, dass elektrische Energie von den Energiespeicherzellen an die Sensoreinrichtung geleitete werden kann.

Moderne Akkumulatoren enthalten eine Vielzahl an Energiespeicherzellen, welche auch als galvanische Zellen oder Akkuzellen bezeichnet werden können. Darüber hinaus verfügt ein moderner Akkumulator zumeist auch über ein Batteriemanagementsystem, um die Funktionen und Abläufe innerhalb des Akkumulators zu überwachen und zu regeln. Ein Balancer (auch als Ausgleichsregler bekannt) ist häufig ein wichtiger Bestandteil des Batteriemanagementsystems. Aufgabe des Balancers ist es, eine möglichst gleichmäßige elektrische Ladungsverteilung über alle Energiespeicherzellen zu gewährleisten. Balancers von Energiespeicherzellen in Akkumulatoren gemäß dem Stand der Technik sind jedoch häufig ineffizient.

Aufgabe der vorliegenden Erfindung ist es daher, ein Verfahren zum Steuern und Regeln eines Akkumulators bereitzustellen, mit dem das Balancing bzw. die gleichmäßige Ladungsverteilung in den Energiespeicherzellen eines Akkumulators verbessert werden kann.

Die Aufgabe wird entsprechend gelöst durch den Gegenstand des unabhängigen Anspruchs 1. Weitere vorteilhafte Ausgestaltungsformen der Erfindung finden sich in den entsprechenden Unteransprüchen.

Die Aufgabe wird insbesondere gelöst durch ein Verfahren zum Steuern und Regeln eines Akkumulators mit wenigstens einer ersten und zweiten Energiespeicherzelle, einer Steuerungselektronik, einer Spannungsmesseinrichtung sowie wenigstens einer Sensoreinrichtung, wobei die Sensoreinrichtung und die Energiespeicherzellen jeweils über wenigstens ein ansteuerbares Schaltelement so miteinander verbunden sind, dass elektrische Energie von den Energiespeicherzellen an die Sensoreinrichtung geleitete werden kann.

Erfindungsgemäß enthält das Verfahren die Verfahrensschritte:
- Erfassen eines ersten Spannungswertes der ersten und zweiten Energiespeicherzelle durch die Spannungsmesseinrichtung; und
- Einstellen des wenigstens einen Schaltelements von einem Deaktivierungsmodus in einen Aktivierungsmodus, wenn die Differenz zwischen dem Spannungswert der ersten Energiespeicherzelle und dem Spannungswert der zweiten Energiespeicherzelle einen vorbestimmten Schwellwert erreicht, um elektrische Spannung von der Energiespeicherzelle mit dem höheren Spannungswert an die Sensoreinrichtung zu leiten.

Gemäß einer vorteilhaften Ausführungsform der vorliegenden Erfindung kann es möglich sein, dass das Verfahren den Verfahrensschritt enthält:
Erfassen eines zweiten Spannungswertes der ersten und zweiten Energiespeicherzelle durch die Spannungsmesseinrichtung nach Ablauf einer ersten Zeitdauer.
Hierdurch kann eine regelmäßige oder unregelmäßige Überwachung bzw. ein regelmäßiges Erfassen des Spannungswerts der einzelnen Energiespeicherzellen erfolgen, um ggf. einen Balancing-Prozess einzuleiten und eine gleichmäßige Ladungsverteilung in den Energiespeicherzellen eines Akkumulators zu erreichen.

Gemäß einer vorteilhaften Ausführungsform der vorliegenden Erfindung kann es möglich sein, dass das Verfahren den Verfahrensschritt enthält:
Erfassen eines zweiten Spannungswertes der ersten und zweiten Energiespeicherzelle durch die Spannungsmesseinrichtung nach Ablauf einer zweiten Zeitdauer, wobei die zweite Zeitdauer in Abhängigkeit zu eine Differenzwert zwischen dem Spannungswert der ersten Energiespeicherzelle und dem Spannungswert der zweiten Energiespeicherzelle steht.
Hierdurch kann die Überwachung bzw. das Erfassen des Spannungswerts der einzelnen Energiespeicherzellen daran angepasst werden, wie schnell oder langsam die elektrische Ladung in den einzelnen Energiespeicherzellen voneinander variiert.

Bei dem Schaltelement kann es sich um einen Metall-Oxid-Halbleiter-Feldeffekttransistor (MOSFET) oder einen anderen geeigneten Feldeffekttransistor (FET) handeln.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:
- Figur 1: eine Seitenansicht auf eine Werkzeugmaschine mit einem Akkumulator zur Ausführung des erfindungsgemäßen Verfahrens;
- Figur 2: eine Schnittansicht auf den Akkumulator mit einer Anzahl an Energiespeicherzellen, einer Steuerungseinrichtung, einer Spannungsmesseinrichtung sowie einer Sensoreinrichtung;
- Figur 3: ein Schaltbild zur Ausführung des erfindungsgemäßen Verfahrens; und
- Figur 4: eine grafische Darstellung des Verhältnisses der Veränderung einer zweiten Zeitdauer zu der Veränderung einer elektrischen Spannung.

### Ausführungsbeispiele:

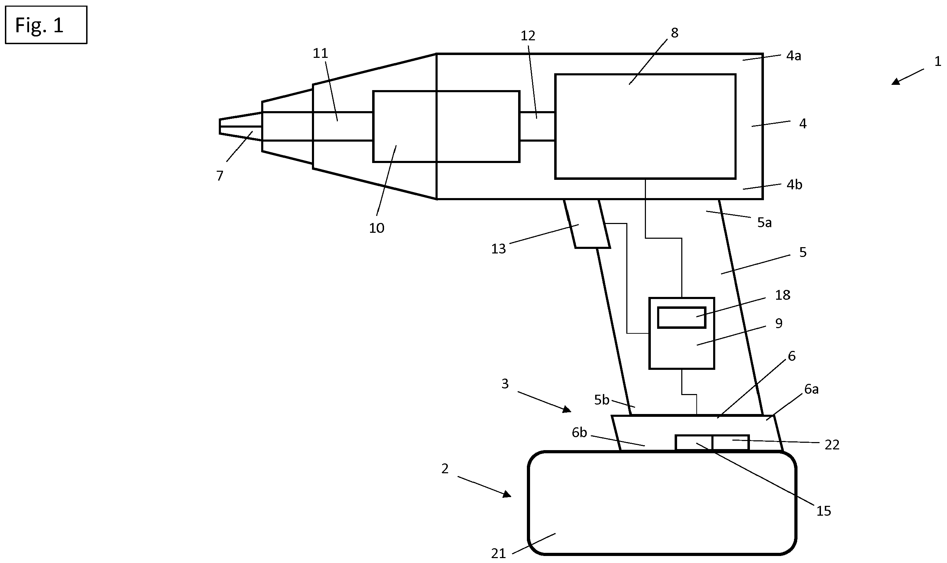

In Figur 1 ist eine Werkzeugmaschine 1 und einem Akkumulator 2 dargestellt. Die Werkzeugmaschine 1 ist in Form eines Akku-Schraubers dargestellt. Gemäß anderer alternativer Ausführungsformen kann die Werkzeugmaschine 1 auch in Form einer Bohrmaschine, einer Säge, eines Schleifgeräts oder dergleichen ausgestaltet sein.

Der Akkumulator 2 ist über eine Schnittstelle 3 mit der Werkzeugmaschine 1 verbunden und dient zur Versorgung der elektrischen Verbraucher der Werkzeugmaschine 1 mit elektrischer Energie. Bei der Versorgung fließt elektrischer Strom von dem Akkumulator 2 zu der Werkzeugmaschine 1.

Die als Akku-Schrauber ausgestaltete Werkzeugmaschine 2 enthält im Wesentlichen ein Gehäuse 4, ein Handgriff 5, ein Fussteil 6, eine Werkzeugaufnahme 7, einen elektrischen Antrieb 8 in Form eines Elektromotors, eine Steuerung 9, ein Getriebe 10, eine Antriebswelle 11, eine Abtriebswelle 12 und einen Aktivierungsschalter 13. Bei dem Elektromotor kann es sich um einen bürstenlosen Elektromotor handeln.
Der als Elektromotor ausgestaltet elektrische Antrieb 8, das Getriebe 10, die Antriebswelle 11, die Abtriebswelle 12 und die Steuerung 9 sind in dem Gehäuse 4 positioniert. Der Antrieb 8, das Getriebe 10, die Antriebswelle 11 und die Abtriebswelle 12 sind so zueinander und in dem Gehäuse 10 positioniert, dass ein von dem Antrieb 8 erzeugtes Drehmoment an die Abtriebswelle 12 übertragen wird. Die Abtriebswelle 12 überträgt das Drehmoment auf das Getriebe 10, welches wiederum ein Drehmoment an die Antriebswelle 11 weitergibt. Über die Antriebswelle 11 wird durch Übertragung des Drehmoments die Werkzeugaufnahme 7 angetrieben. Wie in Figur 1 dargestellt, ist in der Werkzeugaufnahme 7 ein Werkzeug in Form eines Bits gehalten. Mit Hilfe des Bits kann eine Schraube in einen Werkstoff eingeschraubt werden. Weder das Werkzeug, die Schraube noch der Werkstoff sind in den Figuren dargestellt.

Wie weiterhin in Figur 1 gezeigt, enthält das Gehäuse 4 eine Oberseite 4a und eine Unterseite 4b. Der Handgriff 5 enthält ein erstes Ende 5a und ein zweites Ende 5b. An der Unterseite 4b des Gehäuses 4 ist das erste Ende 5a des Handgriffs 5 befestigt. Des Weiteren enthält das Fussteil 6 ein oberes Ende 6a und ein unteres Ende 6b. Das obere Ende 6a des Fussteils 6 ist an dem zweiten Ende 5b des Handgriffs 5 befestigt. Das untere Ende 6b des Fussteils 6 enthält eine Schnittstelle 15 und dient zum mechanischen, elektrischen und elektronischen Verbinden der Werkzeugmaschine 2 mit dem Akkumulator 2. Die Verbindung ist dabei wieder lösbar.

Zur Aufnahme von elektrischer Energie (bzw. elektrischem Strom) enthält die Schnittstelle 15 eine Anzahl an Stromanschlüssen. Die Schnittstelle 15 enthält darüber hinaus Datenanschlüsse zum Senden und Empfangen von Informationen und Daten in Form von Signalen.

Wie Figur 1 zu entnehmen ist, ist die Steuerung 9 der Werkzeugmaschine 1 in dem Handgriff 5 der Werkzeugmaschine 1 positioniert. Die Steuerung 9 der Werkzeugmaschine 1 dient zum Steuern und Regeln verschiedener Vorgänge in Bezug auf die Werkzeugmaschine 1 sowie in Bezug auf den Akkumulator 2. Die Steuerung 9 steuert insbesondere den Strom bzw. die Stromstärke, die von dem Akkumulator 2 zu der Werkzeugmaschine 1 und insbesondere zum Antreiben des als Elektromotor ausgebildeten Antriebs 8 fließt. Des Weiteren dient die Steuerung 9 auch zum Erfassen der elektrischen Spannung, die durch den Akkumulator anliegt.

Die Steuerung 9 der Werkzeugmaschine 2 enthält dabei einen Mikrocontroller 18 (auch als MCU bezeichnet) sowie eine Datenschnittstelle als Bestandteil eines Kommunikationsschaltkreises für eine bilaterale Kommunikation zwischen dem Akkumulator 2 und der Werkzeugmaschine 1. Weder die Datenschnittstelle noch der Kommunikationsschaltkreis sind in den Figuren dargestellt.

Der Akkumulator 2 enthält im Wesentlichen ein Gehäuse 21 mit einer Akku-Schnittstelle 22 sowie eine Vielzahl an Energiespeicherzellen 23. In dem Gehäuse 21 des Akkumulators 2 sind die Energiespeicherzellen 23, eine Steuerungselektronik 24 mit einem Mikrocontroller 25, eine Spannungsmesseinrichtung 26 sowie eine Sensoreinrichtung 27 positioniert.
Bei der Sensoreinrichtung 27 kann es sich beispielsweise um einen Beschleunigungssensor, ein GPS-Sensor (Global Positioning System Sensor), einen Gyro-Sensor, einen Temperatursensor oder einen anderen Sensor handeln, der eine nahezu kontinuierliche Versorgung mit elektrischer Energie für eine ordnungsgemäße und dauerhafte Funktion benötigt.
Die Steuerungselektronik 24 kann auch als Batteriemanagementsystem bezeichnet werden. Der Akkumulator 2 enthält des Weiteren eine Datenschnittstelle als Bestandteil des Kommunikationsschaltkreises für die bilaterale Kommunikation zwischen dem Akkumulator 2 und der Werkzeugmaschine 1. Die Datenschnittstelle des Akkumulators 2 ist in den Figuren nicht dargestellt.
Die Energiespeicherzellen 23 können auch als Akku-Zellen bezeichnet werden und dienen zum Aufnehmen, Speichern und Bereitstellen elektrischer Energie bzw. einer elektrischen Spannung. Bei den Energiespeicherzellen 23 handelt sich um Zellen auf einer Lithium-Ion-Technologie, wobei jede Akku-Zelle eine elektrische Spannung zwischen 2,7 V bis 4,2 V aufweist.

Die Akku-Schnittstelle 22 ist an einer Seite des Gehäuses 21 positioniert. Die Akku-Schnittstelle 22 enthält eine Anzahl an Stromsteckern zum Aufnehmen und Abgeben von elektrischem Strom sowie Datensteckern zum Senden und Empfangen von Signalen zwischen der Werkzeugmaschine 1 und dem Akkumulator 2. Über die Stromstecker kann der elektrische Strom von den Energiespeicherzellen 23 abgegeben werden. Die Datenstecker sind in den Figuren nicht dargestellt.
Die Stromstecker des Akkumulators 2 sind mit den Stromanschlüssen der Werkzeugmaschine 2 verbunden. Ebenso sind die Datenstecker des Akkumulators 2 mit den Datenanschlüssen der Werkzeugmaschine 1 verbunden.
Durch die Verbindung kann elektrische Energie von den Energiespeicherzellen 23 des Akkumulators 2 zu der Werkzeugmaschine 1 fließen. Des Weiteren können Signale zur Kommunikation zwischen dem Akkumulator 2 und der Werkzeugmaschine 1 ausgetauscht werden.

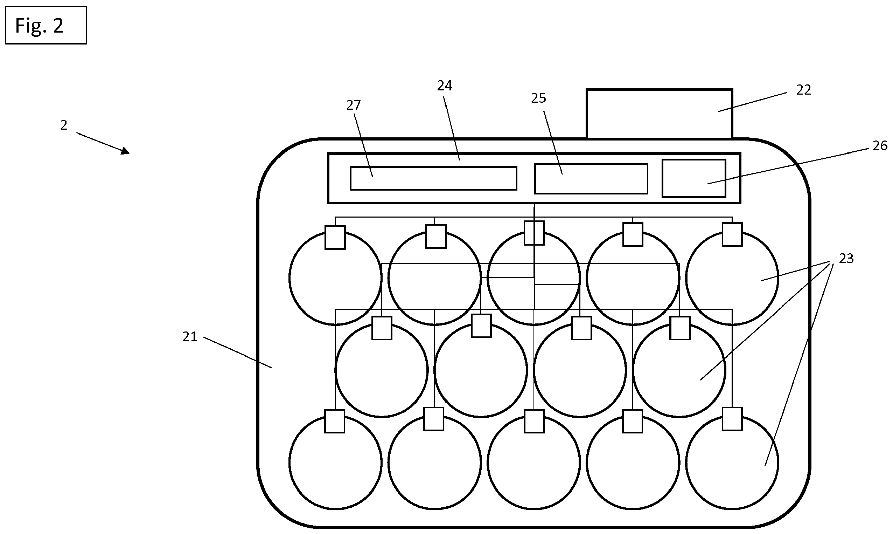

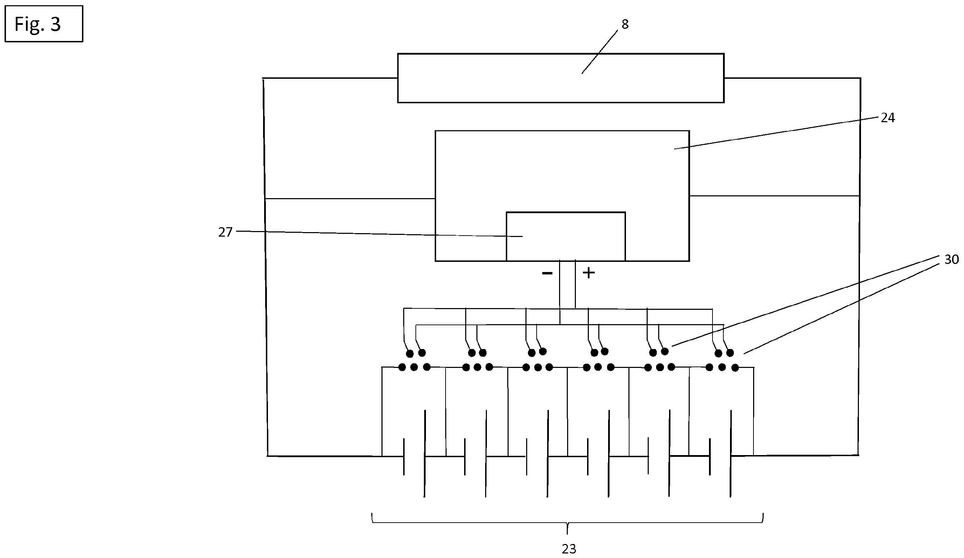

Wie den Figur 2 und 3 zu entnehmen ist, ist jede Energiespeicherzelle 23 jeweils über ein ansteuerbares Schaltelement 30 mit der Steuerungselektronik 24 und der Spannungsmesseinrichtung 26 verbunden. Durch die Verbindung kann die Spannungsmesseinrichtung 26 die elektrische Spannung an jeder Energiespeicherzelle 23 erfassen bzw. messen.

In dem angeführten Ausführungsbeispiel ist das ansteuerbare Schaltelement 30 in Form eines MOSFET ausgestaltet. Das Schaltelement 30 kann durch ein Signal bzw. einen elektrischen Strom angesteuert und reversibel in einen Aktivierungsmodus oder Deaktivierungsmodus eingestellt werden. Die Ansteuerung erfolgt durch die Steuerungselektronik 24. In dem Deaktivierungsmodus ist der Schaltelement 30 so eingestellt, dass eine elektrische Leitung geöffnet und somit die elektrische Leitung unterbrochen ist. In dem Aktivierungsmodus ist hingegen das Schaltelement so eingestellt, dass eine elektrische Leitung geschlossen ist.

Mit Hilfe der Spannungsmesseinrichtung 26 und der Steuerungselektronik 24 kann eine ungleichmäßige Ladungsverteilung bei den Akku-Zellen 23 erfasst werden. Eine ungleichmäßige Ladungsverteilung bei den Akku-Zellen 23 liegt jedoch erst vor, wenn ein vorbestimmter Schwellwert erreicht wird bzw. ein vorbestimmter Schwellwert für die Ladungsdifferenz zwischen zwei Akku-Zellen 23 zerreicht wird. Um eine möglichst gleichmäßige Ladungsverteilung bei den Akku-Zellen 23 zu erreichen, wird mit Hilfe der Steuerungselektronik 24 das Schaltelement 30 angesteuert, welches mit der Akku-Zelle 23 verbunden, die den höchsten Ladungszustand aufweist. Durch das Ansteuern des Schaltelements 30 wird das Schaltelement 30 und die entsprechende Leitung geschlossen, sodass elektrische Energie von der Akku-Zelle 23 mit dem höchsten Ladungszustand zu der Steuerungselektronik 24 fließt. Die elektrische Energie wird von der Steuerungselektronik 24 an die Sensoreinrichtung 27 geleitet und dient damit zur Versorgung der Sensoreinrichtung 27 mit elektrischer Energie.

Das Erfassen bzw. Messen der elektrischen Spannung bzw. des Ladezustands der einzelnen Akku-Zellen 23 erfolgt in regelmäßigen zeitlichen Abständen.

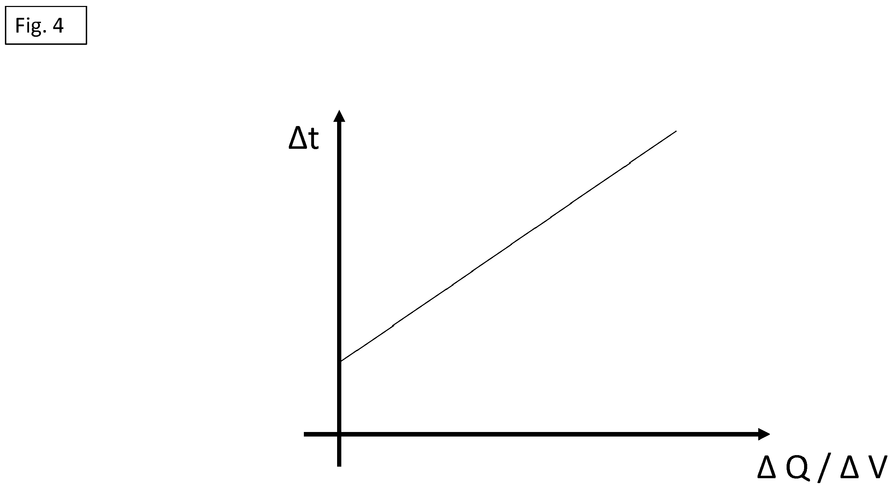

Gemäß einer weiteren Ausführungsform kann es auch möglich sein, dass das Erfassen bzw. Messen der elektrischen Spannung ΔV bzw. des Ladezustands ΔQ (Ah) der einzelnen Akku-Zellen 23 in unregelmäßigen zeitlichen Abständen Δt erfolgt (vgl. Figur 4). So ist es beispielsweise möglich, dass der zeitliche Abstand zwischen einem ersten und zweiten Erfassen abhängig von dem Differenzwert zwischen dem höchsten Ladezustand einer ersten Akku-Zelle 23 und dem niedrigsten Ladezustand einer zweiten Akku-Zelle 23 ist. Je größer der Differenzwert zwischen einem höchsten und niedrigsten Ladezustand, desto kürzer ist der zeitliche Abstand zwischen einem ersten und zweiten Erfassen der elektrischen Spannung bzw. des Ladezustands der einzelnen Akku-Zellen 23.
Ebenso kann der zeitliche Abstand abhängig von dem Ansteigen der Differenz zwischen dem höchsten und niedrigsten Ladezustand der Akku-Zellen 23 sein. Je schneller der Unterschied zwischen dem höchsten und niedrigsten Ladezustand, desto kürzer ist der zeitliche Abstand zwischen einem ersten und zweiten Erfassen der elektrischen Spannung bzw. des Ladezustands der einzelnen Akku-Zellen 23.
Des Weiteren kann der zeitliche Abstand abhängig von dem Rückgang der Differenz zwischen dem höchsten und niedrigsten Ladezustand der Akku-Zellen 23 sein, wenn ein Angleichen der unterschiedlichen Ladezustände (Balancing der Akku-Zellen 23) bereits durch die Steuerungselektronik 24 gestartet wurde. Mit anderen Worten: Je schneller die Angleichung zwischen dem höchsten und niedrigsten Ladezustand, desto kürzer ist der zeitliche Abstand zwischen einem ersten und zweiten Erfassen der elektrischen Spannung bzw. des Ladezustands der einzelnen Akku-Zellen 23.

## Patentansprüche

1. Verfahren zum Steuern und Regeln eines Akkumulators (2) mit wenigstens einer ersten und zweiten Energiespeicherzelle (23), einer Steuerungselektronik (24), einer Spannungsmesseinrichtung (26) sowie wenigstens einer Sensoreinrichtung (27), wobei die Sensoreinrichtung (27) und die Energiespeicherzellen (23) jeweils über wenigstens ein ansteuerbares Schaltelement (30) so miteinander verbunden sind, dass elektrische Energie von den Energiespeicherzellen (23) an die Sensoreinrichtung (27) geleitete werden kann,
**gekennzeichnet durch** die Verfahrensschritte
- Erfassen eines ersten Spannungswertes der ersten und zweiten Energiespeicherzelle (23) durch die Spannungsmesseinrichtung (26); und
- Einstellen des wenigstens einen Schaltelements (30) von einem Deaktivierungsmodus in einen Aktivierungsmodus, wenn die Differenz zwischen dem Spannungswert der ersten Energiespeicherzelle (23) und dem Spannungswert der zweiten Energiespeicherzelle (23) einen vorbestimmten Schwellwert erreicht, um elektrische Spannung von der Energiespeicherzelle (23) mit dem höheren Spannungswert an die Sensoreinrichtung (27) zu leiten.

2. Verfahren nach Anspruch 1,
**gekennzeichnet, durch** Erfassen eines zweiten Spannungswertes der ersten und zweiten Energiespeicherzelle (23) durch die Spannungsmesseinrichtung (26) nach Ablauf einer ersten Zeitdauer.

3. Verfahren nach Anspruch 1 oder 2,
**gekennzeichnet, durch** Erfassen eines zweiten Spannungswertes der ersten und zweiten Energiespeicherzelle (23) durch die Spannungsmesseinrichtung (26) nach Ablauf einer zweiten Zeitdauer, wobei die zweite Zeitdauer in Abhängigkeit zu eine Differenzwert zwischen dem Spannungswert der ersten Energiespeicherzelle (23) und dem Spannungswert der zweiten Energiespeicherzelle (23) steht.
